(19) Europäisches Patentamt
European Patent Office
Office européen des brevets

(11) **EP 3 507 879 B1**

(12) **EUROPÄISCHE PATENTSCHRIFT**

(45) Veröffentlichungstag und Bekanntmachung des Hinweises auf die Patenterteilung:
**28.10.2020 Patentblatt 2020/44**

(21) Anmeldenummer: **17761078.9**

(22) Anmeldetag: **01.09.2017**

(51) Int Cl.:
*H02H 5/04* (2006.01)     *H02H 7/20* (2006.01)
*H01H 83/20* (2006.01)    *H02H 3/08* (2006.01)
*H01L 23/34* (2006.01)    *H02H 6/00* (2006.01)
*H02P 29/68* (2016.01)

(86) Internationale Anmeldenummer:
**PCT/EP2017/071954**

(87) Internationale Veröffentlichungsnummer:
**WO 2018/041994 (08.03.2018 Gazette 2018/10)**

(54) **SCHUTZSCHALTGERÄT**

PROTECTIVE SWITCHING DEVICE

APPAREIL DISJONCTEUR DE PROTECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.09.2016 DE 102016116400**

(43) Veröffentlichungstag der Anmeldung:
**10.07.2019 Patentblatt 2019/28**

(73) Patentinhaber: **Eaton Intelligent Power Limited Dublin 4 (IE)**

(72) Erfinder:
• **HAUER, Wolfgang**
  **4191 Vorderweissenbach (AT)**
• **ASKAN, Kenan**
  **1130 Wien (AT)**

(74) Vertreter: **Eaton IP Group**
**EMEA**
**c/o Eaton Industries Manufacturing GmbH**
**Route de la Longeraie 7**
**1110 Morges (CH)**

(56) Entgegenhaltungen:
EP-A1- 2 254 215     US-A- 4 001 649
US-A- 5 898 557     US-A1- 2016 218 501

EP 3 507 879 B1

**Beschreibung**

Die Erfindung betrifft ein Schutzschaltgerät gemäß dem Oberbegriff des Patentanspruches 1.

Es sind Schutzschaltgeräte bekannt, welche bei einem Überstrom oder einem Kurzschluss einen nachgeordneten Stromkreis abschalten. Hiezu ist es bei elektronischen Schaltgeräten bekannt, neben dem Stromverlauf auch dessen erste Ableitung nach der Zeit, daher dessen Steigung, zu ermitteln, und diese beiden Größen gemeinsam zu bewerten, um festzustellen, ob der gegenwärtige Zustand ein Abschalten des Netzes erforderlich macht.

Dieses, an sich einfach zu implementierende, bekannte Verfahren führt jedoch insbesondere bei schnellen, kurzzeitige und an sich leistungsarmen Stromanstiegen, sog. transienten Vorgängen, wie diese etwa bei Schaltvorgängen auftreten können, unnötigen Auslösungen und Netzabschaltungen. Diese Verfahren weisen daher in der Praxis erhebliche Nachteile auf, und können je nach Einsatzumgebung zu zahlreichen , sicherheitstechnisch nicht erforderlichen Abschaltungen führen.

Bekannte alternative Verfahren mit dem Ziel derartige Fehlauslösungen zu vermeiden, sind weitaus komplexer und aufwendiger in der Implementierung.

Die EP 2 254 215 A1 beschreibt eine elektronische Schaltungsanordnung, welche einen Halbleiterschalter sowie einen Stromsensor zum Messen eines Stromes durch den Halbleiterschalter aufweist. Weiters wird die Umgebungstemperatur auf herkömmliche Weise mittels einen NTC Widerstandes gemessen.

Die US 4 001 649 beschreibt die Ermittlung eines Wertes, welcher proportional der Sperrschichttemperatur ist, wobei dieser Wert aus einem Messsignal des Laststromes ermittelt wird.

Die US 2016/0218501 A1 beschreibt ebenfalls den Schutz der Halbleiterelemente, nicht jedoch einen Schutzschalter, bei dem der Halbleiter selbst wiederum andere oder anderes schützt.

Die US 5 898 557 beschreibt eine elektrische Verteilerbox für ein Auto, welche Verteilerbox einen Halbleiterschalter aufweist. Weiters weist diese eine konventionell aufgebaute Überstromdetektor-Einrichtung auf, sowie ein Anordnung zum Schutz bei hoher Umgebungstemperatur, welche ebenfalls konventionell lediglich die Umgebungstemperatur misst. Die US 5 898 557 beschreibt weiters das Abschalten im Falle hoher Ströme oder hoher Temperatur, wobei die Kabel sowie der Halbleiterschalter geschützt werden sollen.

Aufgabe der Erfindung ist es daher ein Schutzschaltgerät der eingangs genannten Art anzugeben, mit welchem die genannten Nachteile vermieden werden können, mit welchem eine elektrische Anlage sicher vor Kurzschluss- und Überströmen geschützt werden kann, mit welchem eine hohe Verfügbarkeit der Anlage erreicht werden kann, und welches eine hohe Lebensdauer aufweist.

Erfindungsgemäß wird dies durch die Merkmale des Patentanspruches 1 erreicht.

Dadurch kann ein Schutzschaltgerät gebildet werden, welches eine elektrische Anlage sicher vor Kurzschluss- und Überströmen schützt. Das betreffende Schutzschaltgerät ist einfach zu implementieren und weist eine hohe Lebensdauer auf. Durch die Auswertung der Sperrschichttemperatur kann die Anzahl von Fehlauslösungen auch bei transienten Vorgängen reduziert werden, wodurch eine hohe Verfügbarkeit der Anlage erreicht werden kann. Gleichzeitig kann dadurch die Lebensdauer das Schutzschaltgeräts erhöht werden, da mit der Sperrschichttemperatur genau der Parameter überwacht wird, welcher hinsichtlich der Lebensdauer des Halbleiterschalters limitierend sein kann. Dadurch kann durch Überwachung lediglich eines einzigen Kennwertes sowohl die Funktionsfähigkeit der nachgeschalteten elektrischen Anlage wie auch des Schutzschaltgerätes selbst geschützt werden.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen eine lediglich bevorzugte Ausführungsform beispielhaft dargestellt ist, näher beschrieben. Dabei zeigt:

Fig. 1 ein Blockschaltbild einer Ausführungsform eines gegenständlichen Schutzschaltgeräts; und

Fig. 2 eine beispielhafte Darstellung eines Teils eines Halbleiterschalters.

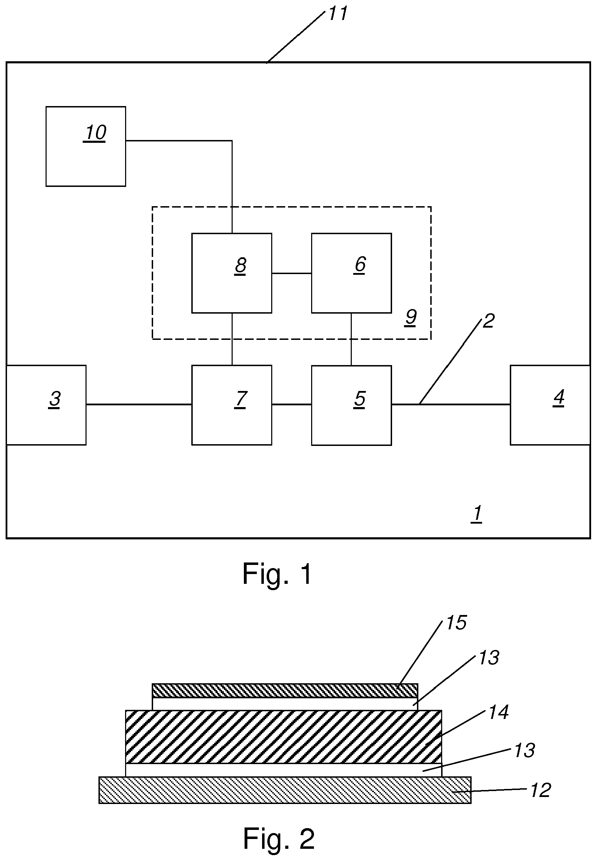

Die Fig. 1 zeigt ein Schutzschaltgerät 1 mit wenigstens einer Schaltstrecke 2 von einer ersten Anschlussklemme 3 des Schutzschaltgeräts 1 zu einer zweiten Anschlussklemme 4 des Schutzschaltgeräts 1, wobei wenigstens ein Halbleiterschalter 5 in der Schaltstrecke 2 angeordnet ist, wobei der Halbleiterschalter 5 zur vorgebbaren Unterbrechung der Schaltstrecke 2 von einem Auslöser 6 des Schutzschaltgeräts 1 angesteuert ist, wobei das Schutzschaltgerät 1 eine Strommessanordnung 7 zur Ermittlung eines Stromverlaufes durch den Halbleiterschalter 5 aufweist, wobei die Strommessanordnung 7 mit einer Kenngrößeneinheit 8 des Schutzschaltgeräts 1 verbunden ist, welche mit dem Auslöser 6 verbunden ist, wobei die Kenngrößeneinheit 8 derart ausgebildet ist, dass aus dem Stromverlauf durch den Halbleiterschalter 5 eine, mit der Sperrschichttemperatur des Halbleiterschalters 5 korrelierend Kenngröße ermittelt wird.

Dadurch kann ein Schutzschaltgerät 1 gebildet werden, welches eine elektrische Anlage sicher vor Kurzschluss- und Überströmen schützt. Das betreffende Schutzschaltgerät 1 ist einfach zu implementieren und weist eine hohe Lebensdauer auf. Durch die Auswertung der Sperrschichttemperatur kann die Anzahl von Fehlauslösungen auch bei transienten Vorgängen reduziert werden, wodurch eine hohe Verfügbarkeit der Anlage erreicht werden kann. Gleichzeitig kann dadurch die Lebensdauer das Schutzschaltgeräts 1 erhöht werden, da mit der Sperrschichttemperatur genau der Parameter überwacht wird, welcher hinsichtlich der Lebensdauer des Halbleiterschalters 5 limitierend sein kann. Dadurch kann durch Überwachung lediglich eines einzigen Kennwertes sowohl die Funktionsfähigkeit der nachgeschalteten elektrischen Anlage wie auch des Schutzschaltgerätes 1 selbst geschützt werden.

Bei einem gegenständlichen Schutzschaltgerät 1 kann es sich um jede Art eines Schutzschaltgeräts 1 handeln, welches eine selbsttätige Unterbrechung eines Stromflusses ermöglicht, sowie die weiteren, beschriebenen Baugruppen aufweist.

Das gegenständliche Schutzschaltgerät 1 weist wenigstens eine Schaltstrecke 2 auf, daher einen Strompfad bzw. Stromweg durch das Schutzschaltgerät 1, welcher vorgebbar unterbrochen werden kann. Das Schutzschaltgerät 1 kann selbstverständlich eine größere Anzahl Schaltstrecken 2 aufweisen. Zum Zwecke der Unterbrechung des Stromflusses über bzw. durch das Schutzschaltgerät 1 weist dieses wenigstens einen Halbleiterschalter 5 innerhalb der Schaltstrecke 2 auf. Darüber hinaus kann das Schutzschaltgerät 1 weitere Halbleiterschalter 5 und/oder mechanische Kontakte in bzw. seriell zu der Schaltstrecke 2 aufweisen, um eine vollständige galvanische Trennung beim Abschalten der Schaltstrecke 2 zu erreichen. Entsprechend ausgebildete Schutzschaltgeräte 1 werden auch als hybride Schutzschalter bezeichnet.

Bei dem Halbleiterschalter 5 handelt es sich bevorzugt um einen IGBT, wobei auch andere Leistungshalbleiter vorgesehen sein können.

Das Schutzschaltgerät 1 weist einen Auslöser 6 auf, welcher funktional mit dem Halbleiterschalter 5 verbunden ist, um diesen zur Unterbrechung und/oder Herstellung der Schaltstrecke 2 anzusteuern.

In bzw. an der Schaltstrecke 2 ist eine Strommessanordnung 7 zur Ermittlung eines Stromverlaufes durch den Halbleiterschalter 5 angeordnet. Die Strommessanordnung 7 kann dabei unterschiedlich ausgebildet sein, etwa umfassend einen Shunt-Widerstand, einen Messwandler oder einem Hallsensor.

Die Strommessanordnung 7 ist bevorzugt als digitale Strommessanordnung 7 ausgebildet, und liefert an deren Ausgang ein entsprechend zeit- und wertdiskretes Stromsignal bzw. einen entsprechenden Stromverlauf. Dabei sind bevorzugt Teile der Strommessanordnung 7 analog ausgebildet. Es kann auch vorgesehen sein, die Strommessanordnung 7 vollständig analog auszubilden, und das, von dieser bereitgestellte analoge Stromsignal nachfolgend zu digitalisieren.

Besonders bevorzugt ist vorgesehen, dass die Strommessanordnung 7 mit einer Kenngrößeneinheit 8 des Schutzschaltgeräts 1 verbunden ist. Die Kenngrößeneinheit 8 bildet dabei aus dem Stromverlauf einen Wert bzw. eine Größe, daher die so bezeichnete Kenngröße, welche in dem Auslöser 6 mit wenigstens einem Grenzwert verglichen wird. Die Kenngrößeneinheit 8 ist entsprechend wenigstens mittelbar mit dem Auslöser 6 verbunden.

Es ist vorgesehen, dass die Kenngrößeneinheit 8 derart ausgebildet ist, dass aus dem Stromverlauf durch den Halbleiterschalter 5 eine, der Sperrschichttemperatur des Halbleiterschalters 5 entsprechende bzw. proportionale Kenngröße ermittelt wird. Die Sperrschichttemperatur bezeichnet dabei im Wesentlichen die jeweils aktuelle Sperrschichttemperatur soweit dies die zeitdiskrete Abtastung bei digitaler Strommessung ermöglicht.

Zur Ermittlung der entsprechenden Kenngröße sind unterschiedliche Modelle bekannt, etwa das sog. Foster-Modell, welches auch als Pi-Modell bekannt ist, oder das Cauer-Modell, welches auch als T-Modell bzw. als Ladder Network bezeichnet wird. Gemäß der bevorzugten Ausführungsform der gegenständlichen Erfindung ist vorgesehen das sog. Cauer-Modell anzuwenden. Sowohl beim Foster-Modell als auch beim Cauer-Modell ist die Berechnung bzw. Ermittlung der Sperrschichttemperatur bzw. der entsprechenden proportionalen Kenngröße mittels äquivalentem RC-Netzwerk möglich.

Fig. 2 zeigt eine beispielhafte Darstellung eines Teils eines Halbleiterschalters 5, umfassend eine Kupferbasis 12, eine Schicht Lot 13, eine Keramikschicht 14, eine weitere Schicht Lot 13, sowie ein Silikonsubstrat 15.

Nachfolgend wird eine Gleichung für die Ermittlung der Sperrschichttemperatur eines entsprechenden Halbleiters angegeben:

$$T_{junction}(t) = u(i(t)) \cdot i(t) \cdot \sum_{i=1}^{n} R_{th,i}\left(1 - e^{-t/(R_{th,i} \cdot C_{th,i})}\right)$$

wobei:

$$R_{th} = \frac{d}{A \cdot \kappa}$$

$$C_{th} = c \cdot \rho \cdot d \cdot A$$

Es kann vorgesehen sein, dass die Kenngrößeneinheit 8 diskret aufgebaut ist, wobei besonders bevorzugt vorgesehen ist, dass die diskret aufgebaute Kenngrößeneinheit 8 einen RC-Tiefpass, vorzugsweise fünfter Ordnung, aufweist, an dessen Eingang die Strommessanordnung 7 anliegt. Dies hat sich als mögliche diskrete Implementierung herausgestellt.

Bevorzugt ist vorgesehen, dass die Kenngrößeneinheit 8 als Teil einer integrierten Schaltungsanordnung, daher eines IC, oder eines Mikrocontrollers 9 bzw. μC, ausgebildet ist. Dadurch ist eine flexible und leistungsstarke Implementierung der Kenngrößeneinheit 8 möglich. Als integrierte Schaltungsanordnung kann auch eine programmierbare Logikbaustein, etwa ein FPGA, vorgesehen sein, in welchem beispielsweise auch ein μC implementiert werden kann.

Dabei kann vorgesehen sein, dass die Kenngrößeneinheit 8 und wenigstens Teile der Strommessanordnung 7 und/oder des Auslösers 6 in derselben integrierten Schaltungsanordnung oder demselben Mikrocontroller 9 angeordnet bzw. ausgebildet sind.

Gemäß einer bevorzugten Ausführungsform ist vorgesehen, dass das Schutzschaltgerät 1 einen Temperatursensor 10 zur Detektion einer Gehäuseinnentemperatur aufweist, und dass ein Ausgang des Temperatursensors 10 mit einem Eingang der Kenngrößeneinheit 9 verbunden ist. Wenngleich die Temperatur innerhalb des Gehäuses 11 des Schutzschaltgeräts 1 in der Regel weitestgehend konstant ist, kann durch das Vorsehen eines Temperatursensors 10 und die Ermittlung und Berücksichtigung der jeweils aktuellen Gehäuseinnentemperatur bei der Ermittlung der Kenngröße, diese genauer ermittelt werden, sowie eine höhere Präzision bei der Auslösung erreicht werden.

Die ermittelte Kenngröße wird bevorzugt im bzw. durch den Auslöser 6 mit wenigstens einer vorgebbaren Grenzsperrschichttemperatur, insbesondere einer Mehrzahl an Grenzsperrschichttemperaturen, verglichen, wobei der Auslöser 6 beim einem Überschreiten der Grenzsperrschichttemperatur den Halbleiterschalter 5 zu einer Unterbrechung der Schaltstrecke 2 ansteuert. Die Grenzsperrschichttemperaturen entsprechen dabei einerseits dem Strom durch das Schutzschaltgerät 1, wobei zusätzlich die rein thermischen Grenzen des betreffenden Halbleiterschalters 5 überwacht werden können. Dadurch ist nicht nur ein sicheres Auslösen des Schutzschaltgeräts 1 möglich, sondern auch gleichzeitig ein hohes Maß an Eigenschutz des Schutzschaltgeräts 1 gegeben.

Fig. 1 zeigt ein Blockschaltbild eines entsprechend ausgebildeten Schutzschaltgeräts 1. Das Schutzschaltgerät 1 weist dabei ein Gehäuse 11 auf, sowie wenigstens eine erste Anschlussklemme 3 und eine zweite Anschlussklemme 4. Zwischen der ersten und der zweiten Anschlussklemme 3, 4 besteht ein Stromweg in Form der Schaltstrecke 2, in welcher der Halbleiterschalter 5 angeordnet ist. Der Schaltstrecke 2 ist die Strommessanordnung 7 zugeordnet. Das Schutzschaltgerät 1 weist weiters die Kenngrößeneinheit 8 auf, welche eingangsseitig mit der Strommessanordnung 7 sowie dem Temperatursensor 10 verbunden ist. Der Ausgang der Kenngrößeneinheit 8 ist mit dem Auslöser 6 verbunden, welcher mit dem Halbleiterschalter 5 wirkverbunden ist. Die Kenngrößeneinheit 8 und der Auslöser 6 sind dabei als Teil eines Mikrocontrollers 9 ausgebildet.

**Patentansprüche**

1. Schutzschaltgerät (1) mit wenigstens einer Schaltstrecke (2) von einer ersten Anschlussklemme (3) des Schutzschaltgeräts (1) zu einer zweiten Anschlussklemme (4) des Schutzschaltgeräts (1), wobei wenigstens ein Halbleiterschalter (5) in der Schaltstrecke (2) angeordnet ist, wobei der Halbleiterschalter (5) zur vorgebbaren Unterbrechung der Schaltstrecke (2) von einem Auslöser (6) des Schutzschaltgeräts (1) angesteuert ist, wobei das Schutzschaltgerät (1) eine Strommessanordnung (7) zur Ermittlung eines Stromverlaufes durch den Halbleiterschalter (5) aufweist, wobei die Strommessanordnung (7) mit einer Kenngrößeneinheit (8) des Schutzschaltgeräts (1) verbunden ist, welche mit dem Auslöser (6) verbunden ist, **dadurch gekennzeichnet, dass** die Kenngrößeneinheit (8) derart ausgebildet ist, dass aus dem Stromverlauf durch den Halbleiterschalter (5) eine, mit der Sperrschichttemperatur des Halbleiterschalters (5) korrelierend Kenngröße ermittelt wird, dass der Auslöser (6) die ermittelte Kenngröße mit wenigstens einer vorgebbaren Grenzsperrschichttemperatur, insbesondere einer Mehrzahl an Grenzsperrschichttemperaturen, vergleicht, und beim einem Überschreiten der Grenzsperrschichttemperatur den Halbleiterschalter (5) zu einer Unterbrechung der Schaltstrecke (2) ansteuert.

**2.** Schutzschaltgerät (1) nach Anspruch 1, **dadurch gekennzeichnet, dass** die Kenngrößeneinheit (8) diskret aufgebaut ist.

**3.** Schutzschaltgerät (1) nach Anspruch 2, **dadurch gekennzeichnet, dass** die diskret aufgebaute Kenngrößeneinheit (8) einen RC-Tiefpass, vorzugsweise fünfter Ordnung, aufweist, an dessen Eingang die Strommessanordnung (7) anliegt.

**4.** Schutzschaltgerät (1) nach Anspruch 1, **dadurch gekennzeichnet, dass** die Kenngrößeneinheit (8) als Teil einer integrierten Schaltungsanordnung oder eines Mikrocontrollers (9) ausgebildet ist.

**5.** Schutzschaltgerät (1) nach einem der Ansprüche 1 bis 4, **dadurch gekennzeichnet, dass** die Kenngrößeneinheit (8) zur Ermittlung der Sperrschichttemperatur auf Basis des Cauer-Modells ausgebildet ist.

**6.** Schutzschaltgerät (1) nach Anspruch 4 oder 5, **dadurch gekennzeichnet, dass** die Strommessanordnung (7) digital ausgebildet ist.

**7.** Schutzschaltgerät (1) nach Anspruch 4, 5 oder 6, **dadurch gekennzeichnet, dass** die Kenngrößeneinheit (8) und wenigstens Teile der Strommessanordnung (7) und/oder des Auslösers (6) in derselben integrierten Schaltungsanordnung oder demselben Mikrocontroller (9) angeordnet bzw. ausgebildet sind.

**8.** Schutzschaltgerät (1) nach einem der Ansprüche 1 bis 7, **dadurch gekennzeichnet, dass** das Schutzschaltgerät (1) einen Temperatursensor (10) zur Detektion einer Gehäuseinnentemperatur aufweist, und dass ein Ausgang des Temperatursensors (10) mit einem Eingang der Kenngrößeneinheit (9) verbunden ist.

**Claims**

**1.** Circuit breaker (1) comprising at least one switching path (2) of a first terminal (3) of the circuit breaker (1) to a second terminal (4) of the circuit breaker (1), wherein at least one semiconductor switch (5) is arranged in the switching path (2), wherein the semiconductor switch (5) is configured to predefinably interrupt the switching path (2) upon actuation by a trigger (6) of the circuit breaker (1), wherein the circuit breaker (1) has a current measuring arrangement (7) for determining a current flow through the semiconductor switch (5), wherein the current measuring arrangement (7) is connected to a characteristic variable unit (8) of the circuit breaker (1), said unit being connected to the trigger (6),
**characterised in that** the characteristic variable unit (8) is configured such that a characteristic variable that is correlated with the junction temperature of the semiconductor switch (5) is determined from the current flow through the semiconductor switch (5), **in that** the trigger (6) compares the determined characteristic variable with at least one predeterminable junction temperature, in particular a plurality of junction temperatures, and if the junction temperature is exceeded actuates the semiconductor switch (5) to interrupt the switching path (2).

**2.** Circuit breaker (1) according to claim 1, **characterised in that** the characteristic variable unit (8) has a discrete structure.

**3.** Circuit breaker (1) according to claim 2, **characterised in that** the characteristic variable unit (8) having the discrete structure has an RC low-pass filter, preferably fifth-order, to the input of which the current measuring arrangement (7) is fitted.

**4.** Circuit breaker (1) according to claim 1, **characterised in that** the characteristic variable unit (8) is designed as a part of an integrated circuit arrangement or a microcontroller (9).

**5.** Circuit breaker (1) according to any of claims 1 to 4, **characterised in that** the characteristic variable unit (8) is designed to determine the junction temperature on the basis of the Cauer model.

**6.** Circuit breaker (1) according to claim 4 or 5, **characterised in that** the current measuring arrangement (7) is designed to be digital.

7. Circuit breaker (1) according to claim 4, 5 or 6, **characterised in that** the characteristic variable unit (8) and at least parts of the current measuring arrangement (7) and/or the trigger (6) are arranged and/or formed in the same integrated circuit arrangement or the same microcontroller (9).

8. Circuit breaker (1) according to any of claims 1 to 7, **characterised in that** the circuit breaker (1) has a temperature sensor (10) for detecting an interior temperature of the housing, and **in that** an output of the temperature sensor (10) is connected to an input of the characteristic variable unit (9).

## Revendications

1. Disjoncteur de protection (1) avec au moins une section de commutation (2) depuis une première borne de raccordement (3) du disjoncteur de protection (1) jusqu'à une seconde borne de raccordement (4) du disjoncteur de protection (1), selon lequel au moins un commutateur à semi-conducteur (5) est disposé dans la section de commutation (2), selon lequel le commutateur à semi-conducteur (5) est commandé par un déclencheur (6) du disjoncteur de protection (1) en vue d'une interruption prédéfinissable de la section de commutation (2), selon lequel le disjoncteur de protection (1) présente un dispositif de mesure de courant (7) en vue d'établir un profil de courant à travers le commutateur à semi-conducteur (5), selon lequel le dispositif de mesure de courant (7) est connecté à une unité de grandeurs caractéristiques (8) du disjoncteur de protection (1), laquelle est connectée au déclencheur (6), **caractérisé en ce que** l'unité de grandeurs caractéristiques (8) est configurée de façon qu'à partir du profil de courant à travers le commutateur à semi-conducteur (5), une grandeur caractéristique corrélée à la température de la couche de déplétion du commutateur à semi-conducteur (5) soit déterminée, **en ce que** le déclencheur (6) compare la grandeur caractéristique déterminée avec au moins une température de couche de déplétion limite prédéfinissable, en particulier avec une pluralité de températures de couche de déplétion limites, et commande, lors d'un dépassement de la une température de couche de déplétion limite du commutateur à semi-conducteur (5), une interruption de la section de commutation (2).

2. Disjoncteur de protection (1) selon la revendication 1, **caractérisé en ce que** l'unité de grandeurs caractéristiques (8) est constituée de manière discrète.

3. Disjoncteur de protection (1) selon la revendication 2, **caractérisé en ce que** l'unité de grandeurs caractéristiques (8) constituée de manière discrète présente un passe-bas RC, de préférence d'ordre cinq, à l'entrée duquel le dispositif de mesure de courant (7) est raccordé.

4. Disjoncteur de protection (1) selon la revendication 1, **caractérisé en ce que** l'unité de grandeurs caractéristiques (8) est configurée comme partie d'un dispositif de commutation intégré ou d'un microcontrôleur (9).

5. Disjoncteur de protection (1) selon l'une des revendications 1 à 4, **caractérisé en ce que** l'unité de grandeurs caractéristiques (8) est configurée en vue de déterminer la température de la couche de déplétion sur la base du modèle de Cauer.

6. Disjoncteur de protection (1) selon la revendication 4 ou 5, **caractérisé en ce que** le dispositif de mesure de courant (7) est configuré de manière numérique.

7. Disjoncteur de protection (1) selon la revendication 4, 5 ou 6, **caractérisé en ce que** l'unité de grandeurs caractéristiques (8) et au moins des parties du dispositif de mesure de courant (7) et/ou du déclencheur (6) sont disposées ou configurées dans le même dispositif de commutation intégré ou le même microcontrôleur (9).

8. Disjoncteur de protection (1) selon l'une des revendications 1 à 7, **caractérisé en ce que** le disjoncteur de protection (1) présente un capteur de température (10) en vue de la détection d'une température interne de boîtier, et **en ce qu'**une sortie du capteur de température (10) est connectée à une entrée de l'unité de grandeurs caractéristiques (9).

Fig. 1

Fig. 2

EP 3 507 879 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2254215 A1
- US 4001649 A
- US 20160218501 A1
- US 5898557 A